# EUROPÄISCHE PATENTANMELDUNG

(11) **EP 1 544 923 A2**
(43) Veröffentlichungstag der Anmeldung: **22.06.2005**
(21) Anmeldenummer: 04029068.6
(22) Anmeldetag: 08.12.2004
(51) Int. Cl.: H01L 33/00, H01L 23/495

(54) **Strahlungemittierendes Halbleiterbauelement und Verfahren zum Befestigen eines Halbleiterchips auf einem Leiterrahmen**

(30) Priorität: 19.12.2003 DE 10359989; 30.01.2004 DE 102004004783
(71) Anmelder: Osram Opto Semiconductors GmbH, 93049 Regensburg (DE)
(72) Erfinder: Pammer, Wolfgang, 93053 Regensburg (DE); Steegmüller, Ulrich, 93059 Regensburg (DE); Höfer, Thomas, 93138 Lappersdorf (DE); Möllmer, Frank, 93080 Matting b. Pentling (DE)
(74) Vertreter: Epping Hermann & Fischer

(57) **Zusammenfassung**

Die vorliegende Erfindung gibt ein strahlungemittierendes Halbleiterbauelement mit einem vorgefertigten Verbund mit einem Leiterrahmen (8) und einem an den Leiterrahmen (8) angeformten Gehäuseteil (9), das einen Kunststoff enthält, und mindestens einem Halbleiterchip (1), der auf dem Leiterrahmen (8) des Verbunds mittels einer Hartlotverbindung (5) befestigt ist. Weiterhin wird ein Verfahren zur Befestigung von Halbleiterchips (1) mittels eines Hartlots auf dem Chipmontagebereich (24) eines Leiterrahmens (23) mit angeformten Gehäuseteil (9) angegeben.

## Beschreibung

Die vorliegende Erfindung betrifft ein strahlungemittierendes Halbleiterbauelement mit einem vorgefertigten Verbund mit einem Leiterrahmen und einem an den Leiterrahmen angeformten Gehäuseteil, das einen Kunststoff enthält, und mindestens einem Halbleiterchip, der auf dem Leiterrahmen des Verbunds befestigt ist, sowie ein Verfahren zur Befestigung mindestens eines Halbleiterchips auf einem Leiterrahmen.

In herkömmlichen derartigen strahlungemittierenden Halbleiterbauelementen ist der Halbleiterchip oftmals über eine Weichlotverbindung auf dem Leiterrahmen befestigt und elektrisch mit diesem verbunden. Weichlote, wie beispielsweise AgSn, CuSn, PbSn oder In-haltige Lote, werden gewöhnlich bei Temperaturen gelötet, die so gering sind, dass keine thermische Deformierung des angeformten Gehäuseteils auftritt. Im Betrieb des Bauelements können jedoch Temperaturen oder Temperaturunterschwankungen, insbesondere im Bereich des Halbleiterchips, der als Hochleistungshalbleiterchip ausgebildet sein kann, auftreten, die die Gefahr einer Ermüdung der Weichlotverbindung erhöhen und in der Folge die Zyklenbeständigkeit des Bauelements verringern können.

Hartlote dagegen weisen in der Regel eine höhere Zyklenbeständigkeit auf, die insbesondere bei Hochleistungslaserchips, im cw-Betrieb (continuous wave) oder Pulsbetrieb, vorteilhaft ist. Wird jedoch ein Hartlot zur Befestigung des Halbleiterchips verwendet, so sind die angeformten Gehäuseteile oft gegenüber den höheren Löttemperaturen, von beispielsweise 280°C oder höher, nicht formstabil, so dass die Gehäuseteile erst nach dem Lötvorgang und häufig in kostenintensiven Einzelbauteilbearbeitungsschritten an den Leiterrahmen angeformt werden.

Oftmals werden aus Effizienz- oder Kostengründen beispielsweise mehrere montierte Halbleiterchips, wie etwa auf Kupferblöcken montierte Laserdiodenbarren, zu Stapeln ("Stacks") zusammengebaut und mit einem gemeinsamen Gehäuse versehen oder in einem gemeinsamen Gehäuse angeordnet. In einem so gebildeten Modul mit mehreren Halbleiterchips kann die Gefahr, dass beim Ausfall eines Halbleiterchips das gesamte Modul unbrauchbar wird, erhöht werden und in der Folge kann es erforderlich sein, das gesamte Modul, inklusive prinzipiell noch funktionsfähiger Halbleiterchips, auszutauschen oder einzelne Halbleiterchips aufwendig zu erneuern.

Eine Aufgabe der Erfindung besteht darin, ein strahlungemittierendes Halbleiterbauelement anzugeben, das eine erhöhte Zuverlässigkeit aufweist und vereinfacht herstellbar ist. Eine weitere Aufgabe der Erfindung ist es, ein vereinfachtes Verfahren zur Befestigung eines Halbleiterchips auf einem Leiterrahmen anzugeben.

Diese Aufgaben werden durch ein strahlungemittierendes Halbleiterbauelement mit den Merkmalen des Anspruchs 1 und ein Verfahren zur Befestigung eines Halbleiterchips gemäß Patentanspruch 12. Vorteilhafte Weiterbildungen der Erfindung sind Gegenstand der abhängigen Ansprüche.

Ein strahlungemittierendes Halbleiterbauelement gemäß der vorliegenden Erfindung umfasst einen vorgefertigten Verbund mit einem Leiterrahmen und einem an den Leiterrahmen angeformten Gehäuseteil, das einen Kunststoff enthält, und mindestens einem Halbleiterchip, der mittels einer Hartlotverbindung auf dem Leiterrahmen des Verbunds befestigt ist.

Der vorgefertigte Verbund mit Leiterrahmen und angeformtem Gehäuseteil erlaubt eine vereinfachte Handhabung des Halbleiterbauelements insbesondere bei dessen Herstellung oder späteren Anwendungen. So kann ein derartiges Halbleiterbauelement in einem Prozess hergestellt werden, in dem keine Einzelbearbeitungsschritte, wie die Anformung eines Gehäuseteils an den Leiterrahmen des Halbleiterbauelements nach dem Befestigen des Halbleiterchips auf dem Leiterrahmen, nötig sind.

Das angeformte Gehäuseteil schützt das strahlungemittierende Halbleiterbauelement, insbesondere den Halbleiterchip, mit Vorteil vor schädlichen äußeren Einflüssen, wie etwa mechanischen Belastungen.

Es sei angemerkt, dass im Rahmen der Erfindung auch einteilige Gehäuse als Gehäuseteil angesehen werden, so dass ein Gehäuse für den Halbleiterchip schon vor dessen Befestigung auf dem Leiterrahmen mittels einer Hartlotverbindung angebracht werden kann.

Die Hartlotverbindung weist eine verglichen mit einer Weichlotverbindung in der Regel höhere Zyklenbeständigkeit, auch bei hohen Betriebstemperaturen, von beispielsweise 250 °C oder mehr, auf, so dass die Gefahr einer Ermüdung der Verbindung vorteilhaft reduziert und die Zuverlässigkeit des Halbleiterbauelements vorteilhaft erhöht werden kann.

Bevorzugt ist der Halbleiterchip über die Hartlotverbindung, elektrisch leitend und/oder wärmeleitend mit dem Leiterrahmen, verbunden. Insbesondere eignet sich ein AuSn enthaltendes Hartlot und/oder ein metallischer Leiterrahmen, zum Beispiel Cu enthaltend. Auf eine zusätzlich zur Hartlotverbindung nötige elektrisch leitende Verbindung zum Leiterrahmen kann so mit Vorteil verzichtet werden, da die elektrische Kontaktierung des Halbleiterchips kann zumindest teilweise über die Hartlotverbindung und den Leiterrahmen erfolgen kann.

Der Halbleiterchip enthält bevorzugt mindestens ein III-V-Halbleitermaterial, umfassend InₓGa_{y}Al_{1-x-y}P, InₓGa_{y}Al_{1-x-y}N oder InₓGa_{y}Al_{1-x-y}As, jeweils mit 0≤x≤1, 0≤y≤1 und x+y≤1.

Insbesondere für einen Halbleiterchip in Form eines Laserchips oder Laserdiodenbarrens, welche im Betrieb eine hohe Wärme erzeugen, ist eine Hartlotverbindung aufgrund ihrer relativ hohen Stabilität bezüglich Temperaturschwankungen vorteilhaft. Besonders vorteilhaft ist eine Hartlotverbindung für Hochleistungs-Laserchips oder -diodenbarren, mit Leistungen von beispielsweise 20 W oder höher.

Das Gehäuseteil wird bevorzugt mittels eines Spritzguss-, Pressguss- oder Spritzpressgussprozesses an den Leiterrahmen angeformt. Dies sind Verfahren, die die Herstellung erfindungsgemäßer strahlungemittierender Halbleiterbauelemente in hohen Stückzahlen geeignet sind. Auf einen Einzelbearbeitungsprozess der einzelnen Bauelemente, wie etwa eine Anformung des Gehäuseteils nach der Befestigung des Chips auf dem Leiterrahmen, kann mit Vorteil verzichtet werden.

In einer bevorzugten Ausgestaltung der Erfindung umgibt das Gehäuseteil den Leiterrahmen so, dass der Schutz des Halbleiterbauelements verbessert und/oder das an den Leiterrahmen angeformte Gehäuseteil mechanisch stabilisiert wird.

Bevorzugt ist das Gehäuseteil aus einem Material gefertigt, das bei Temperaturen, die dem Schmelzpunkt oder Schmelzbereich der Hartlotverbindung entsprechen im wesentlichen formbeständig ist. Diese Temperatur liegt beispielsweise bei AuSn enthaltenden Hartlotverbindungen bei 280 °C oder höher, wie etwa bei 300 °C. Diese gewährleistet die Formbeständigkeit des Gehäuseteils, falls es beim Hartlot-Vorgang wärmeleitend mit dem Hartlot verbunden ist. Häufig kann auch eine Formbeständigkeit des Gehäuseteils bei Temperaturen von 25°C oder mehr über dem Schmelzpunkt der Hartlotverbindung erforderlich sein, um ein nachteiliges Anschmelzen des angeformten Gehäuseteils zu vermeiden.

Weiterhin zeichnet sich das Gehäuseteil bevorzugt durch eine hohe Formbeständigkeit, insbesondere gegenüber hohen Temperaturen oder Temperaturschwankungen aus und/oder enthält das zumindest einen Kunststoff, der besonders bevorzugt auch in den oben genannten Gussverfahren verwendbar und/oder bei den oben.genannten Temperaturen formbeständig ist. PEEK (Polyetheretherketone) enthaltende Kunststoffe können beispielsweise hierbei verwendet werden.

In einer weiteren bevorzugten Ausgestaltung ist der Halbleiterchip auf einer, vorzugsweise elektrisch leitfähigen Wärmesenke, beispielsweise CuW enthaltend, angeordnet, die die Wärmeableitung vom Halbleiterchip vorteilhaft verbessert. Dadurch wird die Gefahr eines Ausfalls des Halbleiterbauelements aufgrund einer hohen Wärmeentwicklung im Bereich des Halbleiterchips reduziert. Der Halbleiterchip ist bevorzugt mittels der Hartlotverbindung auf der Wärmesenke angeordnet und/oder befestigt. Die Wärmesenke ist vorzugsweise zwischen dem Halbleiterchip und dem Leiterrahmen angeordnet. Über ein Verbindungsmittel, etwa ein Hart- oder ein Weichlot, kann die Wärmesenke mit dem Leiterrahmen verbunden sein. Hierbei kann ein Weichlot genügen, da die Wärmesenke die im Betrieb am Halbleiterchip entstehende Wärme über eine relativ große Fläche verteilt, wodurch nachteilige Ermüdungserscheinungen des Weichlots, verglichen mit einer Anordnung des Weichlots direkt am Halbleiterchip, vermieden oder verringert werden können. Somit wird die Zyklenbeständigkeit des strahlungemittierenden Halbleiterbauelements mit Vorteil durch ein Weichlot-Verbindungsmittel nicht wesentlich verringert. Der Halbleiterchip wird hierbei vorzugsweise zuerst mittels der Hartlotverbindung auf der Wärmesenke befestigt, die nachfolgend über ein Weichlot-Verbindungsmittel mit dem Leiterrahmen verbunden wird.

Besonders bevorzugt dient als Verbindungsmittel zwischen Wärmesenke und Leiterrahmen jedoch ebenfalls ein Hartlot, das beispielsweise AuSn enthalten kann. Hiermit wird neben der grundsätzlich höheren Zyklenbeständigkeit mit Vorteil auch die Herstellung des strahlungemittierenden Halbleiterbauelements vereinfacht, da die Lötprozesse des Halbleiterchips auf die Wärmesenke und der Wärmesenke auf den Leiterrahmen so in einem Verfahrensschritt durchgeführt werden können. Auf ein eventuell bei hohen Hartlot-Temperaturen aufschmelzendes Weichlot muss dann nicht geachtet werden.

In einer vorteilhaften Weiterbildung weisen das an der Hartlotverbindung beteiligte Hartlot und das Verbindungsmittel zumindest annähernd den gleichen Schmelzpunkt auf, der vorzugsweise bei einer möglichst geringen Temperatur liegt, um die thermische Beanspruchung des strahlungemittierenden Halbleiterbauelements, insbesondere des angeformten Gehäuseteils, nicht unnötig zu erhöhen. Ferner kann die Befestigung des Halbleiterchips auf der Wärmesenke und der Wärmesenke auf dem Leiterrahmen mit Vorteil in einem Verfahrensschritt durchgeführt werden.

In einer weiteren bevorzugten Ausgestaltung umfasst das strahlungemittierende Halbleiterbauelement ein Gehäuse, vorzugsweise zum Schutz des Halbleiterchips vor schädlichen äußeren Einflüssen. Das Gehäuse umfasst bevorzugt das an den Leiterrahmen angeformte Gehäuseteil, und besonders bevorzugt mindestens ein weiteres Zusatzgehäuseteil, beispielsweise einen Kunststoff, ein Metall oder Stahl enthaltend.

Die Gehäuseteile können beispielsweise über eine Befestigungsvorrichtung, etwa eine Rastvorrichtung oder einen Klebstoff umfassend, miteinander und/oder mit dem Leiterrahmen mechanisch verbunden sein. Auf eine zusätzliche Umhüllung der Halbleiterchips wie etwa mit Silikon, welches nachteiligen Druck auf den Halbleiterchip ausüben und bei Hochleistungschips, insbesondere Laserdiodenchips oder Laserdiodenbarren, einer raschen Alterung unterliegen kann, kann so vorteilhaft verzichtet werden, ohne die Gefahr schädlicher auf den Halbleiterchip einwirkender äußerer Einflüsse zu erhöhen.

Weiterhin weist das Gehäuse vorzugsweise ein strahlungsdurchlässiges Fenster auf. Der Halbleiterchip ist besonders bevorzugt vollständig von dem schützenden Gehäuse umgeben. Das Gehäuse kann neben dem angeformten und dem Zusatzgehäuseteil auch den Leiterrahmen umfassen.

In einer weiteren bevorzugten Ausgestaltung ist dem Halbleiterchip ein optisches Element, beispielsweise eine Linse, ein Wellenleiter, wie etwa ein Lichtwellenleiter, oder eine Faser nachgeordnet. Die Linse kann beispielsweise der Bündelung der vom Halbleiterchip erzeugten Strahlung, der Lichtwellenleiter zur Zuführung der vom Halbleiterchip erzeugten Strahlung zu einem mit dieser Strahlung zu pumpenden Laser dienen. Besonders bevorzugt ist das optische Element zumindest teilweise vom Gehäuse des strahlungemittierenden Bauelements umgeben beziehungsweise in diesem angeordnet.

In einem erfindungsgemäßen Verfahren zur Befestigung mindestens eines Halbleiterchips auf einem Leiterrahmen, wird zunächst mindestens ein Gehäuseteil an einen Leiterrahmen, der einen Chipmontagebereich umfasst, angeformt. Nachfolgend wird der Halbleiterchip mittels eines Hartlots auf dem Chipmontagebereich befestigt. Ein an einen Leiterrahmen vor der Chipmontage angeformtes Gehäuseteil wird oftmals als "premolded" bezeichnet.

Das Anformen des Gehäuseteils erfolgt vorzugsweise mittels eines Spritzguss-, Pressguss- oder Spritzpressgussverfahrens, besonders bevorzugt unter Verwendung eines gegenüber den beim nachfolgenden Hartlöten auftretenden Temperaturen im wesentlichen formbeständigen Kunststoffs. Durch den formbeständigen Kunststoff kann erreicht werden, dass das Gehäuseteil, im Falle einer thermisch leitfähigen Verbindung zwischen dem Hartlot und dem Gehäuseteil, durch die hohen Temperaturen, die insbesondere während des Hartlötvorgangs oftmals auftreten, im wesentlichen nicht geschädigt wird.

Der Leiterrahmen mit dem angeformten Gehäuseteil ist bevorzugt so ausgebildet, dass dem Chipmontagebereich Anschlüsse zur elektrischen Kontaktierung des Chips zugeordnet sind, die mit diesem zumindest teilweise elektrisch leitend verbunden sind oder in einem weiteren Verfahrensschritt, beispielsweise über einen Bonddraht, mit dem Halbleiterchip leitend verbunden werden können. Besonders bevorzugt sind die Anschlüsse zumindest teilweise vom Gehäuseteil umformt. Dies hat den Vorteil, dass die Stabilität des Leiterrahmens mit dem angeformten Gehäuseteil erhöht wird. Weiterhin können so auch Anschlüsse, die anfangs nicht elektrisch oder mechanisch mit dem Leiterrahmen verbunden sind, mechanisch stabilisiert werden.

Bevorzugt ist zumindest eine Befestigungsvorrichtung am Gehäuseteil oder dem Chipmontagebereich vorgesehen, die das Gehäuseteil mechanisch stabilisiert oder die Anbringung eines zusätzlichen Gehäuseteils erleichtert.

Der Halbleiterchip kann als strahlungerzeugender Halbleiterchip, vorzugsweise als LED-Chip, Laserdiodenchip oder Laserdiodenbarren, ausgebildet sein.

In einer bevorzugten Ausgestaltung wird um den Halbleiterchip mindestens ein Zusatzgehäuseteil angeordnet, das zusammen mit dem angeformten Gehäuseteil und eventuell dem Leiterrahmen ein Gehäuse bilden kann, das den Halbleiterchip vor schädlichen äußeren Einflüssen schützt.

In einer bevorzugten Ausgestaltung des Verfahrens wird eine Mehrzahl von Halbleiterchips auf jeweils einem zugeordneten Leiterrahmen befestigt, wobei die Leiterrahmen zu einem Leiterrahmenstreifen verbunden sind. Während des Anformens wird bevorzugt an im wesentlichen jeden Chipmontagebereich der Leiterrahmen des Leiterrahmenstreifens ein Gehäuseteil angeformt, so dass der Chipmontagebereich, insbesondere der auf diesem mittels des Hartlots nachfolgend auf dem Chipmontagebereich befestigte Halbleiterchip, einen vorteilhaften mechanischen Schutz genießt.

In einer bevorzugten Weiterbildung des Verfahrens wird diese Struktur mit Halbleiterchips, Chipmontagebereichen und Gehäuseteil(en) auf dem Leiterrahmenstreifen in Halbleiterbauelemente vereinzelt. Das Zusatzgehäuseteil kann hierbei vor oder nach dem Vereinzeln in Halbleiterbauelemente angebracht werden.

Ein derartiges Verfahren hat den Vorteil, dass Gehäuseteile an einen Leiterrahmenstreifen angeformt werden können, die gegenüber den bei Hartlotprozessen auftretenden Temperaturen formbeständig sind. Weiterhin können so auf kostengünstige und effiziente Weise strahlungemittierende Halbleiterbauelemente mit angeformten Gehäuseteilen hergestellt werden, indem Halbleiterchips auf Leiterrahmen eines Leiterrahmenstreifens mittels eines Hartlots befestigt werden, wobei das Gehäuseteil gegenüber den Hartlöt-Temperaturen formbeständig sein kann.

Insbesondere können so auf kostengünstige Weise Module mit mehreren Halbleiterchips hergestellt werden, wobei jeder Halbleiterchip einen Leiterrahmen mit einem angeformten Gehäuseteil und Anschlüssen umfassen kann, so dass beim Ausfall eines Halbleiterchips vorteilhaft nicht das ganze Modul ausgetauscht oder ein Halbleiterchip aufwendig erneuert werden muss. Es kann vielmehr ein defekter Halbleiterchip mit Gehäuse entfernt und durch ein funktionsfähiges Halbleiterbauelement ersetzt werden.

Die eingangs und in den folgenden Ausführungsbeispielen beschriebenen strahlungemittierenden Halbleiterbauelemente werden bevorzugt unter Anwendung des obigen Verfahrens hergestellt, so dass die Merkmale der Halbleiterbauelemente sich auch auf obiges Verfahren beziehen können und umgekehrt.

Weitere Merkmale, Vorteile und Zweckmäßigkeiten der Erfindung ergeben sich aus den Beschreibungen der folgenden Ausführungsbeispiele in Verbindung mit den Figuren.

Es zeigen
- Figur 1: eine schematische Schnittansicht eines ersten Ausführungsbeispiels eines erfindungsgemäßen strahlungemittierenden Halbleiterbauelements,
- Figur 2: in den Figuren 2A und 2B eine perspektivische. Schrägansicht, sowie eine schematische Schnittansicht eines zweiten Ausführungsbeispiels eines erfindungsgemäßen strahlungemittierenden Halbleiterbauelements und
- Figur 3: in den Figuren 3A, 3B und 3C eine schematische Darstellung eines erfindungsgemäßen Verfahrensablaufs zur Befestigung eines Halbleiterchips auf einem Leiterrahmenstreifen anhand von drei Zwischenschritten.

Gleichartige oder gleichwirkende Elemente besitzen in den Figuren gleiche Bezugszeichen.

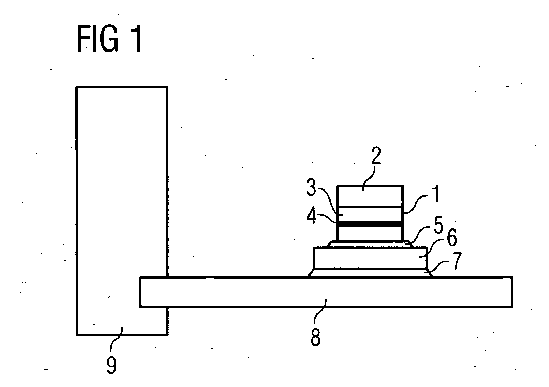

In Figur 1 ist eine schematische Schnittansicht eines ersten Ausführungsbeispiels eines erfindungsgemäßen strahlungemittierenden Halbleiterbauelements dargestellt.

Ein Halbleiterchip 1, der eine auf einem Substrat 2 angeordnete Halbleiterschichtenfolge 3 mit einer Strahlung erzeugenden aktiven Zone 4 umfasst, ist über eine Hartlot 5, beispielsweise AuSn enthaltend, auf einer Wärmesenke 6, vorzugsweise CuW enthaltend, befestigt. Die Wärmesenke 6 leitet die am Halbleiterchip entstehende Wärme, vorzugsweise über den Leiterrahmen 8, ab und verringert so mit Vorteil die Gefahr eines Ausfalls des Halbleiterchips 1 im Betrieb des Bauelements. Die Wärmesenke 6 ist hinsichtlich ihrer thermischen Ausdehnung vorzugsweise an den Halbleiterchip 1 angepasst und ist über ein zweites Lot 7, beispielsweise ein Hartlot wie AuSn enthaltend, auf einem Leiterrahmen 8, etwa ein Metall wie Cu enthaltend, befestigt. Vor der Befestigung des Halbleiterchips 1 auf dem Leiterrahmen 8 wurde ein Gehäuseteil 9 an diesen angeformt, das einen gegenüber den beim Löten auftretenden Temperaturen im wesentlichen formbeständigen Kunststoff wie etwa PEEK oder ein entsprechend ausgebildetes LCP (Liquid Crystal Polymer) enthält. Das Gehäuseteil 9 umgibt den Leiterrahmen 8 bevorzugt zumindest teilweise, oder ist auf andere Weise mechanisch stabil mit diesem verbunden und kann beispielsweise mittels eines Spritz- Spritzpress- oder Pressgussprozesses hergestellt sein. Der Halbleiterchip 1 ist mit dem Leiterrahmen 8 über die Lote 5 und 7 und die Wärmesenke 6 verbunden, wobei diese Verbindung vorteilhafterweise eine hohe mechanische Stabilität aufweist und zugleich als elektrisch leitende Verbindung dient.

In diesem Ausführungsbeispiel ist der Halbleiterchip 1 als Hochleistungslaserchip ausgebildet, der beispielsweise Inₓ Ga_{y} Al_{1-x-y} As, mit 0≤x≤1, 0≤y≤1 und x+y≤1 enthält, eine Emissionswellenlänge im infraroten Spektralbereich, und/oder eine Leistung von 25 W oder mehr aufweist. Das Hartlot 5 und das Lot 7 haben vorzugsweise annähernd gleiche Schmelzpunkte, wobei das Lot 7 ebenfalls als Hartlot ausgebildet sein kann, so dass die Befestigung des Halbleiterchips auf die Wärmesenke 6 und dieser auf den Leiterrahmen 8 in einem Schritt durchgeführt werden kann. Die Verbindung des Halbleiterchips 1 mit der Wärmesenke 6 zeichnet sich hierbei durch eine vorteilhaft hohe Zyklenbeständigkeit aus.

Die zum Aufschmelzen der Lote nötige Wärme wird bevorzugt bei der Herstellung von der dem Halbleiterchip 1 gegenüberliegenden Seite des Leiterrahmens 8 her und in möglichst großer Entfernung von dem Gehäuseteil 9 zugeführt, um eine unnötige thermische Belastung des Gehäuseteils 9 zu vermeiden. Der Halbleiterchip 1 ist daher mit Vorteil in einer möglichst großen Entfernung vom Gehäuseteil 9 angeordnet.

Beim Lötvorgang werden zumindest kurzzeitig Temperaturen von ungefähr 310 °C erreicht, bei denen das.Gehäuseteil 9 mit Vorteil im wesentlichen formbeständig ist. Da das Gehäuseteil 9 bereits vor dem Lötprozess angeformt ist, wird der Halbleiterchip bereits während weiterer Prozessschritte - die nach dem Befestigen auf einem Leiterrahmenstreifen durchgeführt werden - durch das Gehäuseteil vor schädlichen äußeren Einflüssen geschützt.

Der Halbleiterchip 1 ist in diesem Beispiel "Upside-Down" mit dem Substrat 2 auf der dem Leiterrahmen 8 abgewandten Seite der aktiven Zone auf der Wärmesenke 6 befestigt, wodurch die Stabilität der Struktur mit Halbleiterchip 1 und Wärmesenke 6, verglichen mit einer "Upside-Up" Anordnung, in der das Substrat zwischen der aktiven Zone 4 und der Wärmesenke 6 angeordnet wäre, vorteilhaft erhöht werden kann.

Im Materialsystem InₓGa_{y}Al_{1-x-y}As umfasst der Halbleiterchip oftmals ein GaAs-Substrat, dessen thermischer Ausdehnungskoeffizient beispielsweise 6 ppm/K betragen kann. Eine CuW enthaltende Wärmesenke beispielsweise kann, etwa über Variation des Cu- oder W-Anteils, bei ihrer Herstellung an diesen Ausdehnungskoeffizienten angepasst werden. Der Ausdehnungskoeffizient der Wärmesenke beträgt dann mit Vorteil im Falle einer "Upside-Up" Anordnung ebenfalls ungefähr 6 ppm/K. Es versteht sich, dass eine CuW enthaltende Wärmesenke auch mit anderen Ausdehnungskoeffizienten realisiert werden kann, die mit Vorteil an die des seitens des Halbleiterchips an die Wärmesenke angrenzenden Materials angepasst sind oder angepasst ausgebildet sind.

Ein derartiges strahlungemittierendes Bauelement ist bei hoher Zyklenbeständigkeit vereinfacht und kostengünstig herstellbar, da das Gehäuseteil bei den während des Lötvorgangs auftretenden Temperaturen im wesentlichen formbeständig ist und somit bereits vor der Befestigung des Halbleiterchips auf dem Leiterrahmen an diesen angeformt werden kann.

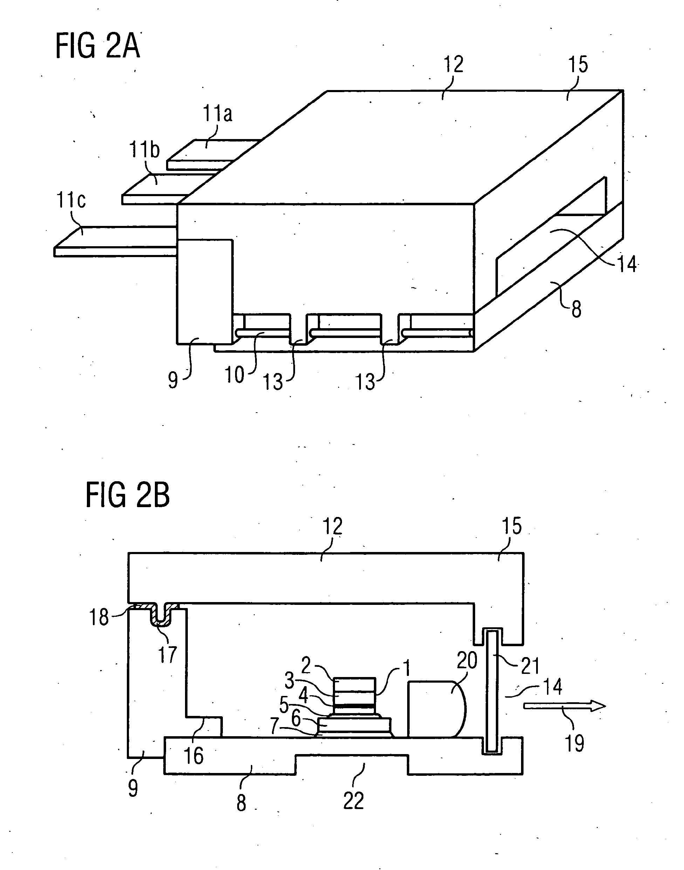

In Figur 2 ist ein zweites Ausführungsbeispiel eines erfindungsgemäßen strahlungemittierenden Halbleiterbauelements anhand einer perspektivischen Schrägansicht in Figur 2A und einer Schnittansicht in Figur 2B schematisch dargestellt.

Die in Figur 2A gezeigte Struktur mit Leiterrahmen 8 und dem an diesen angeformten Gehäuseteil 9 wird durch eine Befestigungsvorrichtung 10, an der das Gehäuseteil 9 angeordnet ist, mechanisch stabilisiert. Die Befestigungsvorrichtung 10 ist vorzugsweise am Leiterrahmen 8 angeordnet oder im Leiterrahmen ausgebildet, beispielsweise in Form einer Rastvorrichtung wie einer geeigneten Aus- oder Einbuchtung. Verglichen mit dem in Figur 1 dargestellten Bauelement kann so die Kontaktfläche zwischen Leiterrahmen 8 und Gehäuseteil 9 und damit die thermische Belastung des Gehäuseteils 9 verringert werden. Dadurch, dass das Gehäuseteil 9 die Anschlüsse 11a, 11b und 11c, die der elektrischen Kontaktierung des Bauelements dienen und mit dem Leiterrahmen mechanisch und/oder elektrisch verbunden sein können, zumindest teilweise umgibt, kann die Stabilität dieser Struktur weitergehend erhöht werden. Eine höhere Stabilität der Struktur mit Gehäuseteil und Leiterrahmen verringert mit Vorteil die Auswirkungen schädlicher äußerer Einflüsse auf einen auf dem Leiterrahmen 8 angeordneten Halbleiterchip.

Die Befestigungsvorrichtung 10 ist in diesem Ausführungsbeispiel auch zur Befestigung eines, beispielsweise ein Metall ,wie etwa Al, Stahl oder einen Kunststoff, wie PEEK oder ein geeignet ausgebildetes LCP, enthaltenden Zusatzgehäuseteils 12 über an diesem vorgesehene Befestigungsmittel 13, beispielsweise für die Befestigungsvorrichtung 10 geeignete Raster, ausgebildet. Das Zusatzgehäuseteil 12 weist ein Fenster 14 auf, durch das die von einem auf dem Leiterrahmen 8 angeordneten Halbleiterchip erzeugte Strahlung, das durch die Gehäuseteile 9 und 12 und den Leiterrahmen 8 gebildete Gehäuse 15 des strahlungemittierenden Halbleiterbauelements verlassen kann. Das so gebildetes Gehäuse 15 verringert weitergehend die Gefahr einer Schädigung des Halbleiterchips 1.

Figur 2B zeigt eine schematische Schnittansicht des in Figur 2A dargestellten Bauelements. Das an den Leiterrahmen angeformte Gehäuseteil 9 weist einen Vorsprung 16 auf, der mit dem Leiterrahmen 8 in_mechanischem Kontakt steht. Das Zusatzgehäuseteil 12 ist mit dem Gehäuseteil 9_über eine Verbindungsvorrichtung 17 verbunden, die beispielsweise eine Ausnehmung im Gehäuseteil 9 und eine dieser entsprechend ausgebildete Ausbuchtung im Zusatzgehäuseteil 12 umfasst, an der ein Verbindungsmittel 18, beispielsweise ein Klebstoff, angeordnet ist, über den das Gehäuseteil 9 mit dem Zusatzgehäuseteil 12 mechanisch verbunden werden kann.

Im Strahlengang der vom Halbleiterchip 1, der beispielsweise als Laserdiodenbarren ausgebildet ist, erzeugten Strahlung 19 ist ein optisches Element 20 und eine strahlungsdurchlässige Fensterschicht 21 angeordnet. Das optische Element 20 ist in diesem Ausführungsbeispiel als Linse ausgebildet, die wie dargestellt auf dem Leiterrahmen 8 angeordnet und/oder befestigt ist. Abweichend hierzu kann das optische Element 20 beispielsweise auch auf der Wärmesenke 6 angeordnet und/oder befestigt sein. Es versteht sich, dass diese Anordnung auch mit einer Mehrzahl oder anderen, insbesondere den weiter oben oder im folgenden genannten, optischen Elementen, realisiert werden kann.

Der Halbleiterchip 1 umfasst wie in dem in Figur 1 dargestellten Ausführungsbeispiel ein Substrat 2, eine Halbleiterschichtenfolge 3 und eine aktive Zone 4 und ist über ein Hartlot 5 auf einer Wärmesenke 6 und diese über ein zweites Lot 7 auf dem Leiterrahmen 8 angeordnet und vorzugsweise elektrisch leitend mit diesem verbunden. Auf der dem Halbleiterchip 1 gegenüberliegenden Seite des Leiterrahmens 8 ist eine Kühlstruktur 22 vorgesehen, beispielsweise in Form von, vorzugsweise in den Leiterrahmen eingefrästen, Kühlkanälen, die eine effiziente Flüssigkeitskühlung erlauben, oder einer Ausnehmung im Leiterrahmen, in der beispielsweise ein Kühlkörper angeordnet werden kann. Der Kühlkörper, beispielsweise ein Cu-Block, ist ebenso wie eine Kühlflüssigkeit bevorzugt thermisch gut an den Leiterrahmen angebunden oder mit diesem verbunden.

Die elektrische Kontaktierung des Halbleiterchips 1 kann beispielsweise über den Leiterrahmen und einen oder mehrere Bonddrähte (nicht dargestellt) erfolgen, die vorzugsweise mit dem Halbleiterchip auf dessen der Wärmesenke gegenüber liegenden Seite und mindestens einem der in Figur 2A gezeigten Anschlüsse 11a, 11b oder 11c elektrisch leitend verbunden sind. Die Verbindung erfolgt dabei zweckmäßigerweise innerhalb des Gehäuses 15, in dem die Anschlüsse, beispielsweise in nicht von dem Gehäuseteil 9 bedeckten Bereichen oder durch andere geeignete Ausbildungen, vom Halbleiterchip 1 aus anschließbar sein können. Bevorzugt wird der Bonddraht vor der Anbringung des Zusatzgehäuseteils 12 mit dem Anschluss verbunden.

Bevorzugt sind die Anschlüsse 11a und 11c für eine Bonddrahtverbindung mit dem Halbleiterchip 1 ausgebildet und somit nicht mit dem Leiterrahmen 8 elektrisch leitend verbunden. Dies ist beispielsweise bei Hochleistungslaserdiodenbarren von Vorteil, in deren Betrieb hohe Strome fließen, die dadurch auf mehrere Anschlüsse und/oder Bonddrähte verteilt werden können. Der Anschluss 11b ist mit dem Leiterrahmen 8 elektrisch leitend verbunden und stabilisiert vorteilhafterweise das angeformte Gehäuseteil 9 mechanisch, welches wiederum vorzugsweise die Anschlüsse 11a und 11c mechanisch stabilisiert.

Der Vorsprung 16 erhöht vorteilhaft die Stabilität der Struktur mit Leiterrahmen 8 und Gehäuseteil 9, insbesondere gegenüber mechanischen Krafteinwirkungen und unter Mitwirkung der Befestigungsvorrichtung 10 aus Figur 2A.

Die Fensterschicht 21, die mit einer Antireflexbeschichtung bezüglich der vom Halbleiterchip erzeugten Strahlung versehen sein kann, ist neben dem Leiterrahmen 8 und den Gehäuseteilen 9 und 12 Teil des Gehäuses 15 des strahlungemittierenden Halbleiterbauelements, das den Halbleiterchip im wesentlichen vollständig umgibt. Dieses Gehäuse 15 verbessert den Schutz des Halbleiterchips 1 bezüglich schädlicher Einflüsse, die vom Fenster 14 her auf den Halbleiterchip 1 einwirken können.

Die Kühlstruktur 22 ermöglicht eine verbesserte Wärmeableitung vom Halbleiterchip 1 über die Wärmesenke 6 und den Leiterrahmen 8, wodurch mit Vorteil die Effizienz des Bauelements erhöht und die Gefahr eines Ausfalls verringert werden können. Eine derartige Kühlstruktur kann beispielsweise in den Leiterrahmen 8 eingefräst werden. Es versteht sich, dass die Kühlstruktur 22 eine von dem dargestellten im wesentlichen rechteckigen Querschnitt abweichende Form aufweisen kann.

Über das optische Element 20 kann die Abstrahlcharakteristik des Halbleiterchips 1 beeinflusst werden, wie etwa durch Kollimation der Strahlung über eine Linse oder andere Strahlformungselemente, die beispielsweise der Strahlhomogenisierung oder der Wellenlängenstabilisierung, wie etwa ein holographisches Bragggitter (HBG), dienen können. Im Falle von Laserdiodenchips oder -barren etwa kann die Divergenz der emittierten Laserstrahlung reduziert werden. Da die Divergenz der Laserstrahlung, insbesondere bei kantenemittierenden Lasern, in verschiedenen Raumrichtungen verschieden sein kann, wird für höher divergente Strahlung beispielsweise eine FAC-Linse (Fast Access Collimation) und für weniger divergente Strahlung eine SAC-Linse (Slow Access Collimation) verwendet.

Derartige optisches Element können beispielsweise GaP enthaltend, das insbesondere für Wellenlängen von 800 nm oder höher ein für eine, vorzugsweise hochbrechende, Linse geeignetes Material darstellt. Abweichend von der Darstellung kann das optische Element auch im Fenster angeordnet sein. Insbesondere kann das optische Element die Fensterschicht umfassen.

Insgesamt ist das in den Figuren 2A und 2B dargestellte Ausführungsbeispiel der Erfindung ebenso wie das in Figur 1 gezeigte Bauelement vereinfacht herstellbar und weist zusätzlich ein Gehäuse auf, dass den Halbleiterchip allseitig vor schädlichen äußeren Einflüssen schützen kann. Dieses Gehäuse kann bereits ausgebildet werden, während der Leiterrahmen noch Teil eines Leiterrahmenstreifens ist, wodurch ein sehr guter Schutz des Halbleiterchips bereits während der weiteren Prozessierung des Leiterrahmenstreifens gewährleistet werden kann. Ein derartiges Gehäuse kann mit Vorteil im wesentlichen dicht gegen Staubpartikel ausgebildet werden.

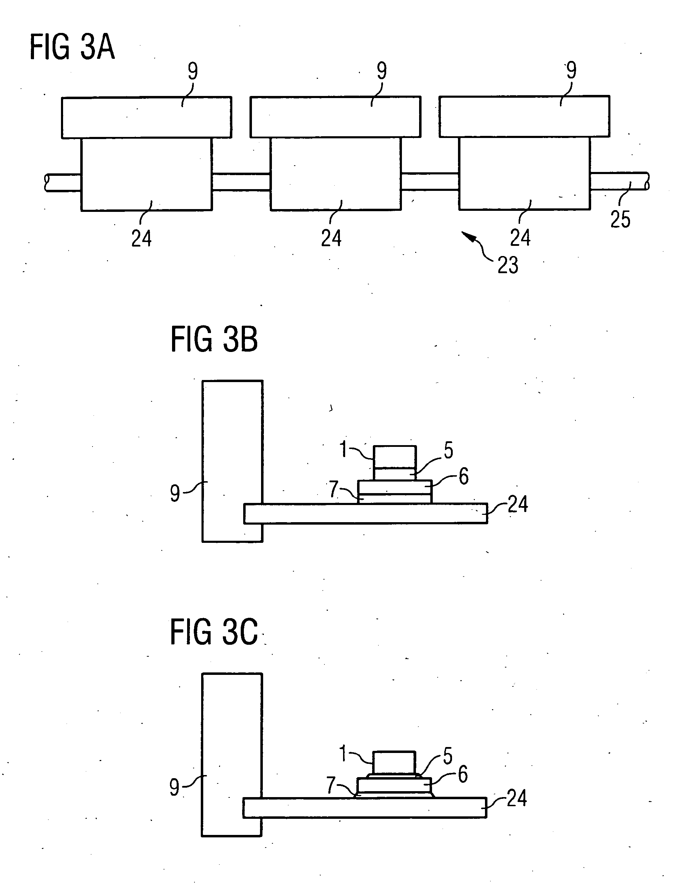

In Figur 3 ist schematisch ein Ausführungsbeispiel eines erfindungsgemäßen Verfahrens zur Befestigung eines Halbleiterchips auf einem Leiterrahmenstreifen anhand der in einer Draufsicht in Figur 3A und Schnittansichten in den Figuren 3B und 3C gezeigten Zwischenschritte dargestellt.

In Figur 3A ist eine schematische Draufsicht von oben auf einen Leiterrahmenstreifen 23 gezeigt, der mehrere Chipmontagebereiche 24 umfasst, die über einen schematisch dargestellten Verbindungsstreifen 25 verbunden sind. Die Chipmontagebereiche 24 enthalten vorzugsweise Cu und können Teil eines Leiterrahmens sein, beispielsweise vom Typ TO 220 oder TO 263, die für die Anwendung bei Hochleistungshalbleiterchips besonders verbreitet sind. Ein an einen Leiterrahmenstreifen vor der Chipmontage angeformtes Gehäuseteil 9 wird oftmals als "premolded" bezeichnet.

In einem ersten Verfahrensschritt wird an die Chipmontagebereiche 24 ein Gehäuseteil 9, vorzugsweise mittels Spritzgießens angeformt. Das Gehäuseteil enthält bevorzugt einen Kunststoff, besonders bevorzugt einen gegenüber hohen Temperaturen formbeständigen Kunststoff, wie beispielsweise PEEK, das bis ungefähr 340°C im wesentlichen formbeständig sein kann. Das Gehäuseteil ist mit dem Chipmontagebereich 24 bevorzugt mechanisch stabil, beispielsweise über eine Befestigungsvorrichtung wie in Figur 2A gezeigt oder eine hier dargestellte zumindest teilweise Umformung des Chipmontagebereichs 24, verbunden, wodurch die weitere Prozessierung der dargestellten Struktur erleichtert wird.

Nachfolgend wird ein Halbleiterchip 1, beispielsweise eine Hochleistungslaserdiodenchip oder -barren, über ein Hartlotmaterial 5, zum Beispiel AuSn enthaltend, auf einer Wärmesenke 6, beispielsweise CuW enthaltend, und diese wiederum über ein weiteres Lotmaterial 7, vorzugsweise ebenfalls ein Hartlotmaterial, beispielsweise AuSn enthaltend, derart auf dem Chipmontagebereich 24 positioniert, dass die Wärmesenke 6, wie in Figur 3B anhand einer schematischen Schnittansicht gezeigt ist, zwischen dem Chipmontagebereich 24 und dem Halbleiterchip 1 angeordnet ist.

Daraufhin werden die Lote 5 und 7, die vorzugsweise annähernd den gleichen Schmelzpunkt oder Schmelzbereich, beispielsweise ungefähr 280°C bis 310°C entsprechend einem AuSn-Lot, aufweisen, in einem weiteren Verfahrensschritt unter Temperaturerhöhung aufgeschmolzen. Die nötige Wärmezufuhr erfolgt hierbei vorzugsweise über die dem Halbleiterchip 1 gegenüberliegende Oberfläche des Chipmontagebereichs 24. Bevorzugt wird der Abstand des Halbleiterchips 1 vom Gehäuseteil 9 dabei möglichst groß gewählt, um die thermische Belastung des Gehäuseteils 9 möglichst gering zu halten. Nachfolgend wird die Wärmezufuhr beendet und die aufgeschmolzenen Lote 5 und 7 können erstarren, was in Figur 3C durch die aufgeweiteten Seitenflanken der Lote 5 und 7 dargestellt ist.

Der Halbleiterchip 1 ist nun auf dem Chipmontagebereich 24, der Teil eines Leiterrahmens sein kann, befestigt und vorzugsweise über die Lote 5, 7 und die Wärmesenke 6 elektrisch und/oder thermisch leitend mit diesem verbunden.

Ein derartiges Verfahren hat den Vorteil, dass Halbleiterchips auf einem Chipmontagebereich, an den zuvor ein Gehäuseteil, insbesondere ein Kunststoff enthaltendes Gehäuseteil angeformt wurde, mittels eines Hartlots befestigt werden können, da das Gehäuseteil gegenüber den zum Hartlöten nötigen Temperaturen formbeständig ist. Die Hartlotverbindung zeichnet sich gegenüber anderen Verbindungsmitteln, wie beispielsweise einer Weichlotverbindung durch eine hohen Zyklenbeständigkeit aus. Dadurch wird die Zuverlässigkeit eines unter Benutzung dieses Verfahrens hergestellten strahlungemittierenden Halbleiterbauelements vorteilhaft erhöht.

Ein weiterer Vorteil des Verfahrens besteht darin, dass es die Herstellung von Bauelementen mit an den Chipmontagebereich angeformtem Gehäuseteil und hartgelöteten Halbleiterchips in hohen Stückzahlen erlaubt. Die Bauelemente können noch im Verbund des Leiterrahmenstreifens mit einem schützenden Gehäuse, wie beispielsweise in Figur 2 gezeigt, versehen werden, wodurch teuere Einzelbauteilbearbeitungsschritte, wie nachträgliches Umspritzen des Leiterrahmens mit einem Gehäuse vermieden werden können.

Die Beschreibung der Erfindung anhand der Ausführungsbeispiele ist nicht als eine Beschränkung der Erfindung auf diese anzusehen. Vielmehr umfasst die Erfindung alle Kombinationen von Merkmalen, die in den Ausführungsbeispielen, der sonstigen Beschreibung oder den Patentansprüchen genannt sind, auch wenn diese Kombinationen nicht Gegenstand eines Patentanspruchs sind.

## Patentansprüche

1. Strahlungemittierendes Halbleiterbauelement mit einem vorgefertigten Verbund mit einem Leiterrahmen (8) und einem an den Leiterrahmen (8) angeformten Gehäuseteil (9), das einen Kunststoff enthält, und
mindestens einem Halbleiterchip (1),_der mittels einer Hartlotverbindung (5) auf dem Leiterrahmen (8) des Verbunds befestigt ist.

2. Strahlungemittierendes Halbleiterbauelement nach Anspruch 1,
**dadurch gekennzeichnet, dass**
der Halbleiterchip (1) mit dem Leiterrahmen (8) über die Hartlotverbindung (5) elektrisch leitend verbunden ist.

3. Strahlungemittierendes Halbleiterbauelement nach Anspruch 1 oder 2,
**dadurch gekennzeichnet, dass**
das Gehäuseteil (9) den Leiterrahmen (8) zumindest teilweise umgibt.

4. Strahlungemittierendes Halbleiterbauelement nach mindestens einem der vorhergehenden Ansprüche,
**dadurch gekennzeichnet, dass**
das Gehäuseteil (9) in einem Spritzguss-, Pressguss- oder Spritzpressgussprozess hergestellt ist.

5. Strahlungemittierendes Halbleiterbauelement nach mindestens einem der vorhergehenden Ansprüche,
**dadurch gekennzeichnet, dass**
das Gehäuseteil (9) bei einer dem Schmelzpunkt der Hartlotverbindung (5) entsprechenden Temperatur formbeständig ist.

6. Strahlungemittierendes Halbleiterbauelement nach mindestens einem der vorhergehenden Ansprüche,
**dadurch gekennzeichnet, dass**
der Halbleiterchip (1) ein Laserdiodenchip oder ein Laserdiodenbarren ist.

7. Strahlungemittierendes Halbleiterbauelement nach mindestens einem der vorhergehenden Ansprüche,
**dadurch gekennzeichnet, dass**
der Halbleiterchip (1) mittels der Hartlotverbindung (5) auf einer zwischen dem Halbleiterchip (1) und dem Leiterrahmen (8) angeordneten Wärmesenke (6) angeordnet ist.

8. Strahlungemittierendes Halbleiterbauelement nach Anspruch 7,
**dadurch gekennzeichnet, dass**
die Wärmesenke (6) über ein Verbindungsmittel (7) auf dem Leiterrahmen (8) angeordnet ist.

9. Strahlungemittierendes Halbleiterbauelement nach Anspruch 8,
**dadurch gekennzeichnet, dass**
das Verbindungsmittel (7) ein Hart- oder ein Weichlot ist.

10. Strahlungemittierendes Halbleiterbauelement nach mindestens einem der vorhergehenden Ansprüche,
**dadurch gekennzeichnet, dass**
der Halbleiterchip (1) in einem Gehäuse (15) angeordnet ist, das das Gehäuseteil (9) und mindestens ein Zusatzgehäuseteil (12) umfasst.

11. Strahlungemittierendes Halbleiterbauelement nach Anspruch 10,
**dadurch gekennzeichnet, dass**
innerhalb des Gehäuses (15) ein optisches Element (20) angeordnet ist.

12. Verfahren zur Befestigung mindestens eines Halbleiterchips (1) auf einem Leiterrahmen (8), mit den Schritten,
a) Anformen mindestens eines Gehäuseteiles (9) an einen Leiterrahmen (8), der einen Chipmontagebereich (24) umfasst;
b) Befestigen des Halbleiterchips (1) auf dem Chipmontagebereich (24) mittels eines Hartlots.

13. Verfahren nach Anspruch 12,
**dadurch gekennzeichnet, dass**
das Anformen des Gehäuseteils (9) mittels eines Spritzguss-, Pressguss- oder Spritzpressgussprozesses erfolgt.

14. Verfahren nach Anspruch 12 oder 13,
**dadurch gekennzeichnet, dass**
das Gehäuseteil (9) einen Kunststoff enthält.

15. Verfahren nach mindestens einem der vorhergehenden Ansprüche,
**dadurch gekennzeichnet, dass**
das Gehäuseteil (9) PEEK enthält.

16. Verfahren nach mindestens einem der vorhergehenden Ansprüche,
**dadurch gekennzeichnet, dass**
das Gehäuseteil (9) während des Hartlötprozesses thermisch leitend mit dem Hartlot (5) verbunden ist.

17. Verfahren nach mindestens einem der vorhergehenden Ansprüche,
**dadurch gekennzeichnet, dass**
während des Hartlötprozesses Temperaturen von über 280 °C, bevorzugt von über 300 °C, auftreten.

18. Verfahren nach mindestens einem der vorhergehenden Ansprüche,
**dadurch gekennzeichnet, dass**
dem Chipmontagebereich (24) Anschlüsse (11a,11b,11c) zur Kontaktierung des Halbleiterchips (1) zugeordnet sind.

19. Verfahren nach Anspruch 18,
**dadurch gekennzeichnet, dass**
die Anschlüsse (11a,11b,11c) zumindest teilweise vom Gehäuseteil (9) umformt sind.

20. Verfahren nach mindestens einem der vorhergehenden Ansprüche,
**dadurch gekennzeichnet, dass**
der Halbleiterchip (1) über eine Hartlotverbindung (5) auf einer Wärmesenke (6) angeordnet wird.

21. Verfahren nach Anspruch 20,
**dadurch gekennzeichnet, dass**
die Wärmesenke (6) über ein Verbindungsmittel (7) derart auf dem Chipmontagebereich (24) angeordnet wird, dass die Wärmesenke (6) zwischen dem Halbleiterchip (1) und dem Chipmontagebereich (24) angeordnet ist.

22. Verfahren nach Anspruch 21,
**dadurch gekennzeichnet, dass**
das Verbindungsmittel (7) ein Hart- oder ein Weichlot ist.

23. Verfahren nach einem der Ansprüche 20 bis 22,
**dadurch gekennzeichnet, dass**
das Hartlot und das Verbindungsmittel (7) zumindest annähernd den gleichen Schmelzpunkt aufweisen.

24. Verfahren nach einem der Ansprüche 20 bis 23,
**dadurch gekennzeichnet, dass**
die Anordnung des Halbleiterchip (1) über das Hartlot auf der Wärmesenke (6) und die Anordnung der Wärmesenke (6) über das Verbindungsmittel (7) auf dem Chipmontagebereich (24) in einem Prozessschritt, insbesondere gleichzeitig, erfolgt.

25. Verfahren zur Befestigung einer Mehrzahl von Halbleiterchips (1) auf jeweils einem zugeordneten Leiterrahmen nach einem der Ansprüche 12 bis 24,
**dadurch gekennzeichnet, dass**
die Leiterrahmen in Form eines Leiterrahmenstreifens (23) miteinander verbunden sind.

26. Verfahren nach Anspruch 25,
**dadurch gekennzeichnet, dass**
nach der Befestigung der Halbleiterchips (1) auf dem jeweils zugeordneten Leiterrahmen (8) des Leiterrahmenstreifens (23) in Halbleiterbauelemente, umfassend jeweils mindestens einen Halbleiterchip (1), mindestens einen Chipmontagebereich (24) und einen Leiterrahmen (8) mit angeformtem Gehäuseteil (9) vereinzelt wird.

27. Verfahren nach Anspruch 25 oder 26,
**dadurch gekennzeichnet, dass**
der Leiterrahmenstreifen (23) eine Mehrzahl von gleichförmig ausgebildeten Leiterrahmen (8) umfasst.
